# EUROPEAN PATENT APPLICATION

(11) **EP 4 738 365 A1**
(43) Date of publication of application: **06.05.2026**
(21) Application number: 24209983.6
(22) Date of filing: 30.10.2024
(51) Int. Cl.: G11C 13/04, G02B 6/00, G02F 1/35, H04B 10/70, G02B 6/10, H04J 14/00

(54) **ABSORPTIVE PHOTONIC MEMORY**

(71) Applicant: Nederlandse Organisatie voor Toegepast-Natuurwetenschappelijk Onderzoek TNO, 2595 DA 's-Gravenhage (NL)
(72) Inventor: The designation of the inventor has not yet been filed
(74) Representative: Nederlandsch Octrooibureau

(57) **Abstract**

An absorptive photonic memory comprises absorptive-photonic-memory material, two single-mode ports respectively arranged to receive and transmit memory light to be absorbed by, stored in and emitted from said absorptive-photonic-memory material, and control light that controls said absorptive-photonic-memory material, a multi-mode port connected to the absorptive-photonic-memory material and a spatial multiplexer that spatially multiplexes the two single-mode ports towards the multi-mode port, said spatial multiplexer comprising a plurality of waveguides in a photonic lantern configuration wherein a first subset of the plurality of waveguides is configured to guide the memory light and a second subset of the plurality of waveguides is configured to guide the control light and at least one passive or active optical circuit.

## Description

### FIELD OF THE INVENTION

The invention relates to an absorptive photonic memory and related method of manufacturing and using the absorptive photonic memory.

### BACKGROUND OF THE INVENTION

Photonic memories are used as quantum memories in, for instance, quantum-communication systems for quantum-entanglement distribution. Such systems use quantum repeaters to teleport quantum states over larger distances. Additional to entangled photon-pair sources and Bell-state measurements, such quantum-repeater systems need quantum memories to operate.

The Atomic Frequency Comb (AFC) protocol is a promising approach to create photonic memories, e.g. for use as quantum memory in a quantum-repeater system. An example of this can be found in "Multimode capacity of atomic-frequency comb" by Ortu et all.

AFC protocols use a specially manufactured crystal with rare-earth doping to achieve large static inhomogeneous broadening, narrow homogeneous broadening and low spectral diffusion. The AFC protocol has several phases:
- In the preparation phase, some high intensity light with finely-tailored spectral, intensity and timing properties is used to prepare the crystal through spectral hole burning, in order to achieve a spectrally finely-tuned combination of atomic states ("ground", "excited", "shelf", ...).
- In the write phase, a photonic pulse is absorbed by the AFC, and in this way it is "written" into the crystal. When used as a quantum memory, single-photon pulses are used. These single photons would typically have a quantum state that is entangled with another photon at another location, e.g. through generation by an entangled photon-pair source.
- In the read phase, the photonic pulse is retrieved. In case of the single photon, the emitted photon has the same quantum state as the absorbed one, and it has retained entanglement with the other photon at the other location.

There are many variations to the AFC protocol, each with its own technological complexity and features. In many cases, the time between write and read is already determined at the preparation phase, as the storage time is determined by the spectral properties of the preparation light. Also, "random-access" AFC implementations are known with long storage time, see for instance "One-hour coherent optical storage in an atomic frequency comb memory" by Ma et al.

The use of a cavity is a known feature for an AFC, see e.g. "Towards a Realistic Model for Cavity-Enhanced Atomic Frequency Comb Quantum Memories" by Taherizadegan et al. A cavity is built from fully and/or partially reflective surfaces (mirrors) that surround absorptive-photonic-memory material. The use of a cavity enhances the storage efficiency, if proper impedance matching is applied. That is, the optical length of the cavity should match with the frequency of the stored photon(s), and the reflectivity of the "mirrors" at the cavity ends should match with the absorption by the crystal, to minimize photon(s) bouncing out of the cavity instead of getting absorbed in the write phase. In the read phase, the re-emitted photon may come out at the same side as where the to-be-absorbed photon entered.

### SUMMARY OF THE INVENTION

According to a first aspect of the invention, it is provided an absorptive photonic memory comprising:
- An absorptive-photonic-memory material;
- Two single-mode ports respectively arranged to receive and transmit memory light to be absorbed by, stored in and emitted from said absorptive-photonic-memory material, and control light that controls said absorptive-photonic-memory material to prepare the absorptive-photonic-memory material, and to control the writing, storage and reading of said memory light;
- A multi-mode port connected to the absorptive-photonic-memory material; and
- A spatial multiplexer that spatially multiplexes the two single-mode ports towards the multi-mode port, said spatial multiplexer comprising a plurality of waveguides in a photonic lantern configuration wherein a first subset of the plurality of waveguides is configured to guide the memory light and a second subset of the plurality of waveguides is configured to guide the control light and at least one passive or active optical circuit connecting one of the two single-mode ports to the first subset of the plurality of waveguides and/or the other one of the two single-mode ports to the second subset of the plurality of waveguides, the at least one passive or active optical circuit comprising at least one beam splitter.

This allows to spatially multiplex the memory light and the control light using the spatial multiplexer. By spatial multiplexing using a photonic lantern configuration a compact and light weight absorptive photonic memory is provided. This might be especially relevant in satellite systems. State-of-the-art systems comprise much bigger bulk components, like beam splitters or optical switches in combination with time multiplexing between the control and the memory light.

Also, the disclosed absorptive photonic memory allows to avoid coupling losses associated with the above-mentioned bulk components thereby providing efficient coupling of the memory light absorbed by the absorptive-photonic-memory material and emitted from said absorptive-photonic-memory material which might be critical in some systems such as quantum-memory systems.

The absorptive photonic memory may further comprise a cavity comprising the absorptive-photonic-memory material.

A reflectivity of a mirror located at an end of the cavity connecting with the spatial multiplexer may be such that there is an impedance match between the spatial multiplexer and the cavity, in order to optimize absorption efficiency.

The control light may be arranged to perform spectral hole burning on the absorptive-photonic-memory material.

At least one of the two single-mode ports may comprise an optical fiber.

The one of the two single-mode ports arranged to receive and transmit control light may comprise an optical fiber coupled to the second subset of the plurality of waveguides using at least one of a butt joint, a grating, and a flip-chip arrangement.

At least one of the first subset of the plurality of waveguides may comprise a curved section or a mirror to guide the memory light and/or the control light.

The absorptive photonic memory may further comprise a third single-mode port configured to receive memory light and the first subset of the plurality of waveguides may comprise two waveguides respectively coupled to the one of the two single-mode ports arranged to receive and transmit memory light and to the third single-mode port, wherein the two waveguides may be connected at a middle section by an optical coupler.

The absorptive photonic memory may further comprise a third single-mode port configured to receive memory light and the first subset of the plurality of waveguides may comprise at least two waveguides respectively coupled to the one of the two single-mode ports arranged to receive and transmit memory light and to the third single-mode port, wherein the two waveguides may be connected at a middle section by an optical coupler and the memory light guided by one of the two waveguides may be 90 degree phase shifted with respect to the memory light guided by the other of the two waveguides.

The one of the two waveguides may be quarter a wavelength of the memory light longer than the other of the two waveguides or it may comprise another type of 90-degree phase shifter.

One of the two waveguides may match a first order mode of the absorptive-photonic-memory material and the other of the two waveguides may match a fundamental order mode of the absorptive-photonic-memory material.

The absorptive photonic memory may be further arranged in a photonic integrated circuit.

The absorptive photonic memory may be further arranged in a 3-dimensional configuration.

According to a second aspect of the invention, a method of manufacturing the absorptive photonic memory as described above is provided.

According to another aspect of the invention, a method of controlling the absorptive photonic memory as above described is provided.

### BRIEF DESCRIPTION OF THE DRAWINGS

The invention will be described further with respect to embodiments shown in the drawings.
FIG. 1 shows schematically an absorptive photonic memory according to an embodiment of the disclosure.
FIG. 2 shows schematically an absorptive photonic memory according to a second embodiment of the disclosure.
FIG. 3 shows schematically an absorptive photonic memory according to a third embodiment of the disclosure.
FIG. 4 shows schematically an absorptive photonic memory according to a fourth embodiment of the disclosure.
Fig. 5A shows a flowchart of a method of manufacturing an absorptive photonic memory according to an embodiment of the disclosure.
Figs. 5B and 5C show respectively a flowchart of a method of reading an absorptive photonic memory and a flowchart of a method of writing an absorptive photonic memory according to embodiments of the invention.

### DESCRIPTION

The following is a description of certain embodiments of the invention, given by way of example only and with reference to the figures. It is also to be understood that the terminology used herein is for the purpose of describing particular aspects only and is not intended to be limiting.

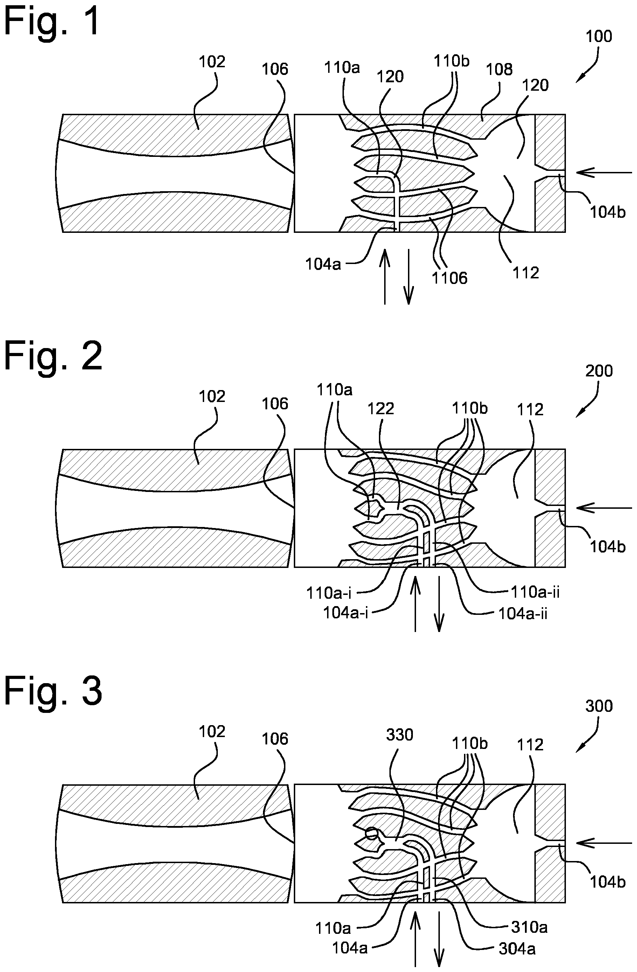

Fig. 1 shows an absorptive photonic memory according to an embodiment of the disclosure.

Fig. 1 shows absorptive photonic memory 100 comprising a cavity made of absorptive-photonic-memory material 102, a first single-mode port 104a, a second single-mode port 104b, a multi-mode port 106 and a spatial multiplexer 108.

The first single-mode port 104a is arranged to receive and transmit memory light. The second single-mode port 104b is arranged to receive control light. The memory light may be emitted by a first light source (not shown in Fig. 1) and may be absorbed and stored in the absorptive-photonic-memory material 102. The memory light may be further emitted from the absorptive-photonic-memory material 102. The control light may be emitted by a second light source (also not shown in Fig. 1). The control light is arranged to control the absorptive-photonic-memory material 102 to prepare the absorptive-photonic-memory material, and to control the writing, storage and reading of the absorptive-photonic-memory material 102.

The multi-mode port 106 is connected to the absorptive-photonic-memory material 102.

The spatial multiplexer 108 spatially multiplexes the first and second single-mode ports towards the multi-mode port 106. The spatial multiplexer 108 comprises five waveguides 110 arranged in a photonic lantern configuration. However, this is a non-limiting example and the spatial multiplexer 108 may comprise any number of waveguides.

A first subset 110a of the plurality of waveguides is configured to guide the memory light. A second subset 110b of the plurality of waveguides is configured to guide the control light. In the embodiment shown in Fig. 1, the first subset 110a comprises only one waveguide while the second subset 110b comprises four waveguides. However, Fig. 1 is a non-limiting example and the spatial multiplexer 108 may comprise any number of waveguides that may be distributed among the first and second subsets in any suitable way.

The spatial multiplexer 108 further comprises at least one passive or active optical circuit connecting the first single-mode port 104a to the first subset 110a of the plurality of waveguides and/or the second single-mode port 104b to the second subset 110b of the plurality of waveguides. The at least one passive or active optical circuit comprises at least one beam splitter 112.

The spatial multiplexer 108 may comprise any number of passive and/or active optical circuits. For instance, the spatial multiplexer 108 may comprise a first passive or active optical circuit connecting the first single-mode port 104a to the first subset 110a of the plurality of waveguides and a second passive or active optical circuit connecting the second single-mode port 104b to the second subset 110b of the plurality of waveguides.

The spatial multiplexer 108 may comprise a photon lantern arranged in a 3-dimensional configuration. An embodiment of such 3D configuration may be a single single-mode optical fiber, surrounded by layers of 6, 12, 18, 24, ... additional optical fibers in a hexagonal pattern. In an embodiment, the central fiber is used for the memory light, whereas control light is distributed over the surrounding additional optical fibers. Alternatively, the spatial multiplexer 108 may be arranged in a photonic integrated circuit (PIC) and have a 2-dimensional configuration.

The five waveguides 110 of Fig. 1 have a refractive index higher than the surrounding material to guide the memory and the control light. The five waveguides 110 may be dimensioned to operate in a single mode. The five waveguides 110 expand at the left side into the multi-mode port 106. The spatial multiplexer 108 is designed to couple the memory and the control light efficiently to the fundamental mode of the cavity.

If the cavity has a low finesse (meaning that the spectral width of its modes is sufficiently wide), then the cavity can couple efficiently multiple spatial modes.

The control light may be arranged to perform spectral hole burning on the absorptive-photonic-memory material 102. Also, the spatial multiplexer 108 of Fig. 1 allows that control light is much more uniformly distributed over the absorptive-photonic-memory material 102, which might be a crystal. If the control light would cover the same fundamental mode as the memory light, then the spectral-hole burning performed by the control light through the AFC protocol would be much less intense around the edges of the fundamental mode of the cavity, than in the center of the cavity. This provides a higher-quality absorptive-photonic-memory (higher efficiency and fidelity). The embodiments are described for a cavity. However, the invention applies also for an absorptive photonic-memory material without any mirrors and/or comprising a single mirror and/or comprising two mirrors at opposing sides thereby forming a cavity. As further examples, the absorptive photonic-memory material may comprise only one 100% reflective mirror at the left side to improve efficiency and/or comprise a partially reflective mirror at the right side as well. In the latest case, it will be is a low-finesse cavity, because of the absorptive photonic-memory material and the lower reflectivity of the mirror at the right.

In an embodiment, the absorptive photonic memory 100 may comprise one or more optical fibers. Specifically, the first and/or the second single mode-port may comprise an optical fiber coupled to the spatial multiplexer 108 respectively for the preparation light and the memory light. As said, in an embodiment, the spatial multiplexer 108 is implemented on a photonic integrated circuit (optical chip).

In an embodiment, the optical fiber/s may be coupled with a butt joint, using well-known techniques to minimize coupling losses, like for instance tapers. In an embodiment, the optical fiber/s is coupled at the surface of the spatial multiplexer 108, using a grating to direct the control and/or the memory light from or into the optical fiber. In an embodiment, the memory and/or the control light are coupled from one optical chip to another using a flip-chip arrangement and overlapping tapered sections in the plurality of waveguides 110 to achieve the required evanescent coupling between the plurality of waveguides 110. In an embodiment, this technique is used for both the control light and the memory light to avoid having to strongly bend the waveguide, and hence avoiding associated bend losses. For instance, in a chip the waveguides are located near/at its top surface. When designed so, a waveguide can have an evanescent optical field slightly above the surface, which can be used to couple the light from/to another (2D) devices that is placed ("glued") on top.

In an embodiment, the memory light is not routed through a bend 120 in the waveguide 110a, but through a sharp corner comprising a mirror using a reflective coating in the waveguide 110a and/or through total internal reflection in the waveguide 110a. The sharp corner would act like a mirror, where the light reflects, while the bend is gradual.

In an embodiment, the control light is distributed over the four waveguides 110b through a 1-to-N beam splitter 112. In an embodiment, this beam splitter is composed of a series of 1-to-2 beam splitters to achieve the required split. In an embodiment, this 1-to-N beam splitter 112 is implemented as a second photonic lantern. In an embodiment, this series of 1-to-2 beam splitters, or this second photonic lantern is integrated with a first photonic lantern forming the spatial multiplexer 108 on a single PIC as illustrated in Fig.1.

In an embodiment, the cavity may comprise two mirrors that are impedance-matched such that the reflectivity of the mirror at the input of the cavity is tuned to optimize absorption and minimize reflection. In an embodiment, the two mirrors of the cavity are separate from the crystal of the cavity. In an embodiment, the two mirrors are coated onto the crystal of the cavity. In an embodiment, the shape of the mirrors of the cavity are tuned to have optimal coupling between the fundamental mode of the cavity and the memory light. In an embodiment, the two mirrors are placed in a confocal arrangement. In an embodiment, the cavity comprising the two mirrors are integrated into the same PIC as the first photonic lantern and/or second photonic lantern.

Again, the technical benefits of all these embodiments are combinations of higher efficiency, quality, compactness and/or light weight of the AFC system. The latter two are especially relevant in satellite systems.

In an embodiment, the memory light in and out are separated with an optical coupler or beam splitter. This increases simplicity, compactness and easy integration with the PIC at the price of a 75% photon loss, 50% for the memory light in, and another 50% for the memory light output.

In another embodiment, the memory light in and out are separated with an optical switch. This avoids losses associated with an optical coupler or beam splitter but it requires for active electronics and more difficult integration with the PIC.

In a further embodiment, the memory light in and out are separated with an optical circulator. The technical benefits are the absence of the losses associated with an optical coupler or beam splitter, and the absence of active electronics. Disadvantages are the bulkiness of an optical circulator, and the difficulty of integrating one with the PIC. Moreover, the magnetic field of an optical circulator may interfere with the magnetic field for the cavity to get the required energy-level splitting.

The frequencies of the control light should match with the energy-level differences between the relevant states of the inhomogeneously broadened material (doped crystal) of the absorptive-photonic-memory material 102.

Fig.2 provides an additional embodiment to separate the memory light in and out. Same reference numbers as in Fig. 1 will be used to indicate same elements. In Fig. 1, the spatial multiplexer 108 comprises 6 waveguides wherein 4 waveguides 110b are coupled to the second single mode port 104b. The spatial multiplexer 108 comprises further two separated single-mode ports 104-i and 104-ii to respectively guide the memory light in and out.

The spatial multiplexer 108 comprises two waveguides 110a-i and 110a-ii among the 6 waveguides respectively coupled to the two separated single-mode ports 104-i and 104-ii. The two waveguides 110a-i and 110a-ii are connected at a middle section by an optical coupler 122, which may be a 50/50 optical coupler.

In this way, the memory light in will excite both the symmetric fundamental mode and an anti-symmetric first-order mode of the waveguide 110a-i with a 90-degrees phase difference. Incoming photon(s) will be absorbed by the superposition of those two modes. Because of phase differences, output photons will leave the PIC from the other waveguide of the two waveguides 110a-i and 110a-ii than where they entered as long as the fundamental and first-order modes are degenerate. That is, that the fundamental and first-order modes have the same absorption and spectral characteristics in the absorptive-photonic-memory material 102. This increases simplicity, compactness and easy integration with the PIC, and avoids losses associated with a coupler when only using the fundamental mode as in Fig. 1.

Fig. 3 shows a further embodiment wherein the absorptive photonic memory 300, compared to the absorptive photonic memory 100, comprises a third single-mode port 304a configured to also receive memory light as the first single-mode port 104a. The first subset of the plurality of waveguides comprises two waveguides 110a and 310a respectively coupled to the single-mode port 104a and 304a and respectively arranged to receive and transmit memory light. The two waveguides 110a and 310a are connected at a middle section by an optical coupler 330 and the memory light guided by one of the two waveguides is 90 degree phase shifted with respect to the memory light guided by the other of the two waveguides. To achieve this, one of the two waveguides 110a and 310a may be half a wavelength of the memory light longer than the other of the two waveguides or may comprise another type of 90-degree phase shifter. One of the two waveguides 110a and 310a matches a first order mode in the photonic lantern and the other of the two waveguides matches a fundamental order mode in the photonic lantern. The photonic lantern is the left part of the spatial multiplexer 108 that combines the plurality of waveguides into the cavity.

In this way, further spatial multiplexing is used to create multiple photonic memories into a single crystal, by using multiple modes in the absorptive-photonic-memory material for this. For example, both the fundamental and first-order mode are used for storage, using the configuration of Fig.3. The design is similar to Fig. 2, but now a 90-degrees phase shifter is added to one of the arms of the coupler. As said, in one embodiment, this 90-degrees phase shift is achieved by making one arm slightly (a quarter optical wavelength) longer than the other. In another embodiment, this 90-degrees phase shift is achieved by varying the geometry of the waveguide. The result is that if the memory in-out light is connected to one waveguide, then only the fundamental mode in the absorptive-photonic-memory material 102 is excited. When the memory in-out light is connected to the other waveguide, then only the first-order mode in the absorptive-photonic-memory material 102 is excited.

In further embodiments, also other higher-order modes may be used for further spatial multiplexing to create even more separate photonic-memory capacity. Here, three or more waveguides may be used for the memory light, in combination with a photonic network of couplers and phase shifters, to also excite second-order, third order and/or even higher-order modes of the absorptive-photonic-memory material 102.

In an embodiment, also spectral multiplexing and time multiplexing may be used to further increase the number of separately-accessible photonic memories in a single crystal. For instance, phase/intensity-tuning the control light would allot to control/optimize the illumination and coupling of the control light.

Multiplexing photonic memories as described would increase compactness, compared to having separate cavities for each individual photonic memory.

In an embodiment, the waveguide(s) for the memory light are routed to the same side as for the control light. This makes easier coupling with other components, e.g. through bonding optical fibers.

In an embodiment, the waveguides for the control light that are not crossed by waveguide(s) for the memory light have a fake crossing opposite to the actual crossings. This provides higher symmetry for the control light, and hence higher uniformity of the spectral-hole burning into the crystal of the absorptive-photonic-memory material 102. Crossings are always needed in a 2D configuration, to separate out the memory light. In 3D configurations, "overpasses" (cf traffic, highways) could be used, and waveguides no longer cross each other, but may go over/under.

In an embodiment, the photonic lantern is three dimensional, where the control light surrounds the memory light from all sides, and a three-dimensional (bulk) crystal is placed in the cavity. In an embodiment, the photonic lantern is created by fusing optical fibers. In another embodiment, the photonic lanterns uses tapered optical fibers, tapering from the separated single-mode region to the combined multimode region. An embodiment of such 3D configuration may be a single single-mode optical fiber, surrounded by layers of 6, 12, 18, 24, ... additional optical fibers in a hexagonal pattern. In an embodiment, the central fiber is used for the memory light, whereas control light is distributed over the surrounding additional optical fibers. A technical benefit for 3D may be using the full volume of the crystal, instead of a layer, and the need to confine the light to that layer.

In an embodiment, the memory light originates from a single-photon source, and the AFC system is used as quantum memory to store and retrieve the quantum state of that single photon. In a further embodiment, the quantum state is a dual-rails polarization state. In another further embodiment, that quantum state is a dual-rails time-bin state. In an embodiment, that quantum state is a dual-rails multi-spatial-mode state, e.g. using higher-order spatial modes as described earlier. In an embodiment, the single-photon source is one of the outputs from an entangled-photon-pair source. In an embodiment, that entangled-photon-pair source is implemented using spontaneous parametric down conversion or spontaneous four-wave mixing. In an embodiment, the source of the memory light is integrated with the PIC for the photonic lantern. In an embodiment, the AFC system is used as part of a quantum repeater (a so-called "untrusted" quantum repeater), where other parts may include entangled-photon-pair source(s), Bell-state measurement(s), synchronization and LOCC communication.

In an embodiment, an anti-reflective coating is applied to the chip facet to increase coupling efficiency.

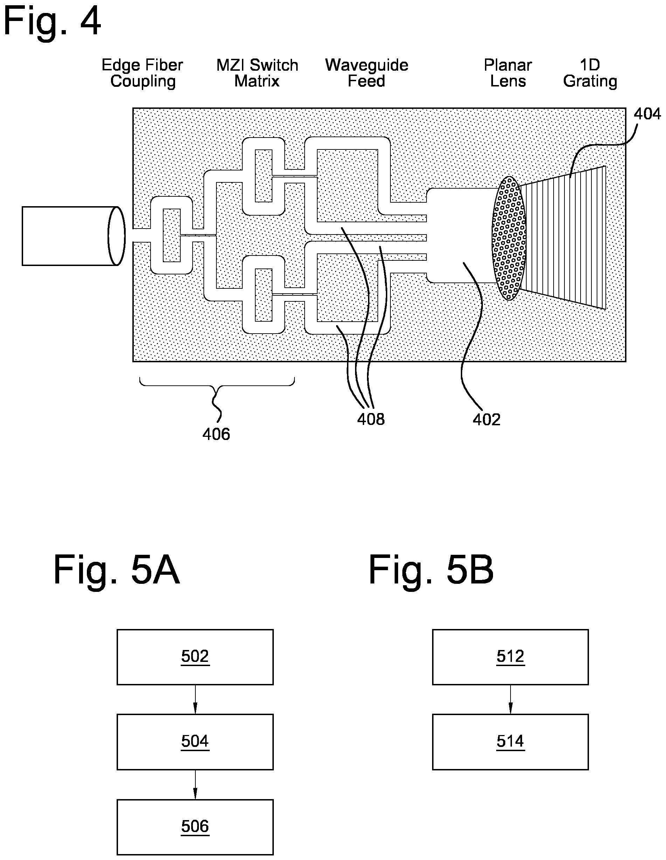

In an embodiment, a lens-type structure is used on the chip facet between the photonic lantern and the cavity to increase coupling efficiency. In an embodiment, this lens is engraved/embedded/included with the photonic lantern itself. In an embodiment, this lens is micro-3D-printed on the facet of the photonic lantern. In an embodiment, this lens is an external lens. The lens might be a Fresnel lens or any other suitable lens. The right-hand side of Figure 4 illustrates a photonic lantern with an embedded planar lens 402 and a 1D grating 404.

In an embodiment, Fig. 4 may comprise active components that are used to tune phase and/or amplitude of the paths that are used for the control light. This enables the active control and optimize of the illumination pattern (intensity and phase distribution) of the control light from the photonic lantern into the cavity, improving coupling efficiency and/or quality of the AFC operation. In an embodiment, one or more Mach-Zehnder Interferometers (MZI) switches are included in the paths for the control light to enable more detailed tuning, steering and further optimization. The left-hand side of Figure 4 illustrates a photonic lantern with an MZI switch matrix 406. In an embodiment, the MZI switch matrix 406 and phase control are combined for further detailed control of the illumination pattern.

In an embodiment, the above-mentioned phase tuning is achieved through heating electrode near the waveguides 408. This has the benefit that a linear low-loss material like SiN3 (Silica Nitrate) can be used for the photonic chip. In an embodiment, the above-mentioned phase tuning is achieved with electrodes near waveguide 408, using the Kerr effect with a non-linear material, like LiNbO3 (Lithium Niobate). In an embodiment, different materials (e.g. SiN3 for the cavity and LiNbO3 for the photonic lantern, or vice versa) are used, enabling separate optimizations. In an embodiment, a flip-chip construction is used to connect one chip of one material with a base in the other material.

In an embodiment, the connection points for the memory light and the preparation light are swapped, where now the latter couples with the fundamental mode. This enables to create a smaller beam width for the memory light, which will then experience a more uniform control light, resulting into a higher-quality memory. This also enables finer control of the memory light for more efficient coupling into and out of the cavity.

In an embodiment, a combination is made of two or more of any previously-described embodiments.

Fig. 5A shows a flowchart of a method of manufacturing a absorptive photonic memory according to an embodiment of the invention. The method of Fig. 5A comprises a first step 502 of providing an absorptive-photonic-memory material, a second step 504 of providing a spatial multiplexer 108, and a third step 506 of coupling the absorptive-photonic-memory material and the multiplexer 108.

Fig. 5B shows a flowchart of a method of reading the absorptive photonic memory of Figs. 1,2 and/or 3. The method of Fig. 5B comprises a first step 512, wherein the control light is guided through the first set 110b of waveguides to the cavity to prepare the cavity for a reading operation. The method of Fig. 5B goes then to step 514 wherein the memory light is emitted from the cavity and guided through one of the waveguides of the second set 110a from the cavity to one of the two single-mode ports 104.

Fig. 5C shows a flowchart of a method of writing the absorptive photonic memory of Figs. 1,2 and/or 3. The method of Fig. 5C comprises a first step 522 wherein the control light is guided through the first set 110b of waveguides to the cavity to prepare the cavity for a writing operation. The method of Fig. 5C goes then to step 524 wherein the memory light is guided through one of the waveguides of the first set 110b from one of the two single-mode ports 104 to the cavity to be absorbed by and stored in the absorptive-photonic-memory material.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

## Claims

1. An absorptive photonic memory (100; 200; 300) comprising:
- An absorptive-photonic-memory material (102);
- Two single-mode ports (104) respectively arranged to receive and transmit memory light to be absorbed by, stored in and emitted from said absorptive-photonic-memory material (102), and control light that controls said absorptive-photonic-memory material (102) to prepare the absorptive-photonic-memory material, and to control the writing, storage and reading of said memory light;
- A multi-mode port (106) connected to the absorptive-photonic-memory material (102); and
- A spatial multiplexer (108) that spatially multiplexes the two single-mode ports (104) towards the multi-mode port (106), said spatial multiplexer comprising:
∘ a plurality of waveguides (110) in a photonic lantern configuration wherein a first subset of the plurality of waveguides (110a) is configured to guide the memory light and a second subset of the plurality of waveguides (110b) is configured to guide the control light; and
∘ passive or active optical circuits connecting one of the two single-mode ports (104a) to the first subset of the plurality of waveguides (110a) and the other one of the two single-mode ports (104b) to the second subset of the plurality of waveguides (110b), said optical circuits comprising at least one beam splitter (112).

2. The absorptive photonic memory (100; 200; 300) according to claim 1, further comprising a cavity comprising the absorptive-photonic-memory material (102), said cavity comprising of fully and/or partially reflecting surfaces that surround said absorptive-photonic-memory material.

3. The absorptive photonic memory (100; 200; 300) according to claim 2, wherein reflectivity of a mirror located at an end of the cavity connecting with the spatial multiplexer (108) is such that there is impedance matching with the absorptive-photonic-memory material.

4. The absorptive photonic memory (100; 200; 300) according to any of the preceding claims, wherein the control light is arranged to perform spectral hole burning on the absorptive-photonic-memory material (102).

5. The absorptive photonic memory (100; 200; 300) according to any of the preceding claims, wherein at least one of the two single-mode ports (104) comprises an optical fiber.

6. The absorptive photonic memory (100; 200; 300) according to claim 1, wherein the one of the two single-mode ports (104b) arranged to receive control light comprises an optical fiber coupled to the second subset of the plurality of waveguides (110b) using at least one of a butt joint, a grating, and a flip-chip arrangement and/or the other one of the two single-mode ports (104a) comprises another optical fiber coupled to the first subset of the plurality of waveguides (110a) using another at least one of a butt joint, a grating, and a flip-chip arrangement.

7. The absorptive photonic memory (100; 200; 300) according to any of the preceding claims, wherein at least one of the first subset of the plurality of waveguides (110a) comprises a curved section or a mirror to guide the memory light.

8. The absorptive photonic memory (200) according to any of the preceding claims, further comprising a third single-mode port configured to receive memory light and wherein the first subset of the plurality of waveguides (110a) comprises two waveguides respectively coupled to the one of the two single-mode ports (104a-i) arranged to receive and transmit memory light and to the third single-mode port (104a-ii), wherein the two waveguides are connected at a middle section by an optical coupler.

9. The absorptive photonic memory (300) according to any of claims 1-7, further comprising a third single-mode port configured to receive memory light and wherein the first subset of the plurality of waveguides (110a) comprises at least two waveguides respectively coupled to the one of the two single-mode ports arranged to receive and transmit memory light and to the third single-mode port, wherein the two waveguides are connected at a middle section by an optical coupler and wherein the memory light guided by one of the two waveguides is 90 degree phase shifted with respect to the memory light guided by the other of the two waveguides.

10. The absorptive photonic memory (300) according to claim 9, wherein the one of the two waveguides is quarter a wavelength of the memory light longer than the other of the two waveguides or comprises another type of 90-degree phase shifter.

11. The absorptive photonic memory (300) according to any of claims 7-8 wherein one of the single-mode ports matches a first order mode in the absorptive-photonic-memory material (102) and another single-mode port matches a fundamental order mode in the absorptive-photonic-memory material (102).

12. The absorptive photonic memory (100; 200; 300) according to any of the preceding claims, further arranged in a photonic integrated circuit.

13. The absorptive photonic memory (100; 200; 300) according to any of the preceding claims, further arranged in a 3-dimensional configuration.

14. A method for using the absorptive photonic memory (100; 200; 300) according to any of claims 1-13.

15. A method of manufacturing the absorptive photonic memory (100; 200; 300) according to any of claims 1-13.
